(19)

Europäisches
Patentamt
European
Patent Office
Office européen
des brevets

(11) **EP 2 085 900 A1**

(12) **EUROPEAN PATENT APPLICATION**

(43) Date of publication:
**05.08.2009 Bulletin 2009/32**

(51) Int Cl.:
***G06F 17/50*** *(2006.01)*

(21) Application number: **08005890.2**

(22) Date of filing: **27.03.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **31.01.2008 US 23796**

(71) Applicant: **Qualcomm Incorporated
San Diego, CA 92121-1714 (US)**

(72) Inventors:
• **Yan, Hongbo
San Diego
CA 92121-1714 (US)**
• **Filipovic, Daniel, F.
San Diego
CA 92121-1714 (US)**

(74) Representative: **Heselberger, Johannes et al
Patent- und Rechtsanwälte
Bardehle - Pagenberg - Dost
Altenburg - Geissler
Galileiplatz 1
81679 München (DE)**

(54) **Crystal oscillator frequency calibration**

(57)     Techniques are disclosed for estimating a frequency of a crystal oscillator based on temperature. In an embodiment, the oscillator frequency is computed using a polynomial approximation. Techniques are disclosed for deriving and periodically updating the coefficients used in the polynomial approximation.

FIG. 4

EP 2 085 900 A1

**Description**

**TECHNICAL FIELD**

The disclosure relates to crystal oscillators and, more particularly, to techniques for estimating the frequency of crystal oscillators.

BACKGROUND

Crystal oscillators (XO) are used in communications devices as frequency sources. In a typical crystal oscillator, a quartz crystal having a nominal resonant frequency is coupled to an oscillator circuit that generates a signal having a nominal output frequency. In practice, the crystal's resonant frequency and the circuit's output frequency may vary over time due to factors such as temperature, aging, drive level and vibration.

In communications applications, frequency sources are typically required to meet strict accuracy requirements, thereby mandating the use of compensation schemes to improve the frequency accuracy of the crystal oscillator. Disclosed herein are techniques to estimate the crystal oscillator frequency, and account for variations of the crystal oscillator frequency over temperature.

**SUMMARY**

An aspect of the present disclosure provides a method for computing coefficients for use in a polynomial approximation of a crystal oscillator frequency, the polynomial comprising a term c0' and a coefficient c1' times a measured temperature T of the crystal oscillator, the method comprising measuring a first temperature T1 and a corresponding oscillator frequency Fm(T1); measuring a second temperature T2 and a corresponding oscillator frequency Fm(T2); computing the coefficient c0' based on Fm(T1); and computing the coefficient c1' based on T1, T2, Fm(T1), and Fm(T2).

Another aspect of the present disclosure provides a method for computing coefficients for use in a polynomial approximation of a crystal oscillator frequency, the polynomial comprising a term c0' and a coefficient c1' times a measured temperature T of the crystal oscillator, the method comprising entering a state FIELD0, operations in the state FIELD0 comprising computing the coefficient c0' if the measured temperature T is within a first range of temperatures; and entering a state FIELD1, operations in the state FIELD1 comprising computing the coefficient c1' if the measured temperature T is within a second range of temperatures.

Yet another aspect of the present disclosure provides an apparatus for computing coefficients for use in a polynomial approximation of a crystal oscillator frequency, the polynomial comprising a term c0' and a coefficient c1' times a measured temperature T of the crystal oscillator, the apparatus comprising a temperature measurement unit for measuring a first temperature T1 and a second temperature T2; a frequency measurement unit for measuring corresponding oscillator frequencies Fm(T1) and Fm(T2); and a computing module for computing the coefficient c0' based on Fm(T1), and for computing the coefficient c1' based on T1, T2, Fm(T1), and Fm(T2).

Yet another aspect of the present disclosure provides a computer program product for computing coefficients for use in a polynomial approximation of a crystal oscillator frequency, the polynomial comprising a term c0' and a coefficient c1' times a measured temperature T of the crystal oscillator, the product comprising computer-readable medium comprising code for causing a computer to measure a first temperature T1 and a corresponding oscillator frequency Fm(T1); code for causing a computer to measure a second temperature T2 and a corresponding oscillator frequency Fm(T2); code for causing a computer to compute the coefficient c0' based on Fm(T1); and code for causing a computer to compute the coefficient c1' based on T1, T2, Fm(T1), and Fm(T2).

Yet another aspect of the present disclosure provides an apparatus for computing coefficients for use in a polynomial approximation of a crystal oscillator frequency, the polynomial comprising a term c0' and a coefficient c1' times a measured temperature T of the crystal oscillator, the apparatus comprising means for entering a state FIELD0, operations in the state FIELD0 comprising computing the coefficient c0' if the measured temperature T is within a first range of temperatures; and means for entering a state FIELD1, operations in the state FIELD1 comprising computing the coefficient c1' if the measured temperature T is within a second range of temperatures.

Yet another aspect of the present disclosure provides a computer program product for computing coefficients for use in a polynomial approximation of a crystal oscillator frequency, the polynomial comprising a term c0' and a coefficient c1' times a measured temperature T of the crystal oscillator, the product comprising computer-readable medium comprising code for causing a computer to enter a state FIELD0, operations in the state FIELD0 comprising computing the coefficient c0' if the measured temperature T is within a first range of temperatures; and code for causing a computer to enter a state FIELD1, operations in the state FIELD1 comprising computing the coefficient c1' if the measured temperature T is within a second range of temperatures.

BRIEF DESCRIPTION OF DRAWINGS

FIG 1 shows a block diagram of a crystal 100 coupled to an oscillator circuit 110 to form a crystal oscillator.

FIG 1A plots a typical variation of a crystal's resonant frequency over temperature and crystal cutting angle.

FIG 2 depicts steps according to the present disclosure for estimating the coefficients c0, c1, c2, c3.

FIG 2A depicts an alternative embodiment of the present disclosure.

FIG 2B depicts an embodiment of a technique for measuring a frequency offset Fm(T1) at the receiver.

FIG 3A depicts a linear relationship between c1' and c2' denoted by L1/2.

FIG 3B depicts a similar linear relationship between c1' and c3' that can be used to compute an estimate of c3' from c1'.

FIG 4 shows a state machine used to re-adjust an initially calibrated set of coefficients derived from, e.g., the procedure described in FIG 2.

FIG 5 shows an embodiment of operations performed during state FIELD0.

FIG 6 shows an embodiment of operations performed during state FIELD1.

FIG 7 shows an embodiment of operations performed during state FIELD3.

## DETAILED DESCRIPTION

Disclosed herein are techniques to estimate the frequency of a crystal oscillator based on its measured temperature.

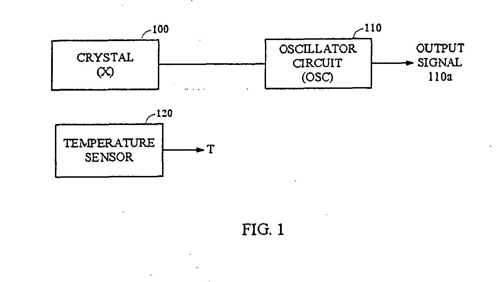

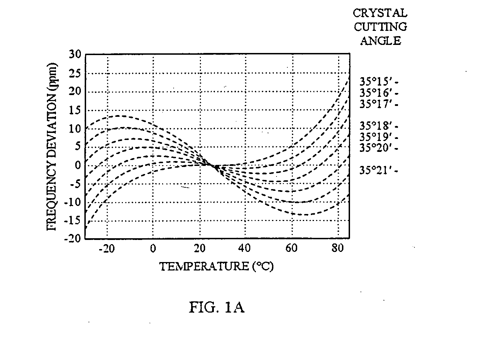

FIG 1 shows a block diagram of a crystal 100 coupled to an oscillator circuit 110 to form a crystal oscillator. The temperature of the crystal 100 is measured by temperature sensor 120, which generates a measured temperature T. The crystal oscillator generates an output signal 110a having a nominal reference frequency.

In an embodiment, the temperature T may be the temperature measured locally at the crystal. In an alternative embodiment (not shown), an additional temperature $T_O$ corresponding to the oscillator circuit local temperature may be measured and provided to improve the frequency estimate, as further described hereinbelow.

FIG 1A plots a typical variation of a crystal's resonant frequency over temperature and crystal cutting angle. It has been shown in the prior art that the relationship between crystal temperature and crystal resonant frequency may be approximated by a polynomial equation as follows (Equation 1):

$$F_x(T) = a3\,(T - T_0)^3 + a2\,(T - T_0)^2 + a1\,(T - T_0);$$

wherein T represents the crystal temperature, $T_0$ represents a fixed reference temperature, $F_X(T)$ represents the shift in crystal resonant frequency at temperature T relative to a nominal frequency $F_{X0}$, and a1, a2, a3 are coefficients characterizing the particular crystal sampled. In general, the coefficients a1, a2, a3 are determined by the crystal's physical properties, including its cutting angle. See, e.g., Arthur Ballato, "Frequency-Temperature-Load Capacitance Behavior of Resonators for TCXO Application," IEEE Trans. Sonics and Ultrasonics, Vol. SU-25, No.4, July 1978.

When the crystal 100 is coupled to the oscillator circuit 110 as shown in FIG 1, the frequency of the oscillator output signal 110a may vary over temperature as follows (Equation 2):

$$F_O(T, T_O) = c3\,(T - T_0)^3 + c2\,(T - T_0)^2 + c1\,(T - T_0)^2 + c0 + cp\,(T_O - T_{O0}).$$

In Equation 2, T represents the crystal temperature, $T_0$ represents a fixed reference temperature, $F_O(T, T_O)$ represents the predicted frequency shift of the signal 110a at temperature T relative to a reference frequency $F_{O0}$, $T_O$ represents the oscillator temperature, $T_{O0}$ represents a fixed oscillator reference temperature, c0, c1, c2, c3 are coefficients characterizing the oscillator output signal 110a's frequency dependence on crystal temperature, and cp is a coefficient characterizing the oscillator output signal 110a's frequency dependence on oscillator temperature. The coefficient cp may depend on, e.g., the capacitance loading the oscillator circuit.

In an embodiment, the coefficient cp is derived by comparing a nominal F-T curve of the crystal provided by a crystal vendor with an F-T curve measured using a fully loaded crystal oscillator. The measurement may be done offline, e.g., in a laboratory.

Alternatively, to derive cp, the crystal temperature may be fixed, while the oscillator temperature varied from a first temperature To1 to a second temperature To2. The corresponding oscillator output frequencies Fo(To1) and Fo(To2) may be measured. The coefficient cp may then be estimated as follows (Equation 2a):

$$cp = [\ Fo(To1) - Fo(To2)\ ]\ /\ (To1 - To2).$$

Since the coefficient cp is generally fixed for a given oscillator design, only a one-time measurement needs to be performed to estimate the coefficient. The estimate can subsequently be used for all implementations of the crystal oscillator.

According to an aspect of the present disclosure, techniques are provided to compute $F_O(T)$ according to Equation 2, using measured temperatures T and $T_O$, and estimates of the coefficients c0, c1, c2, c3.

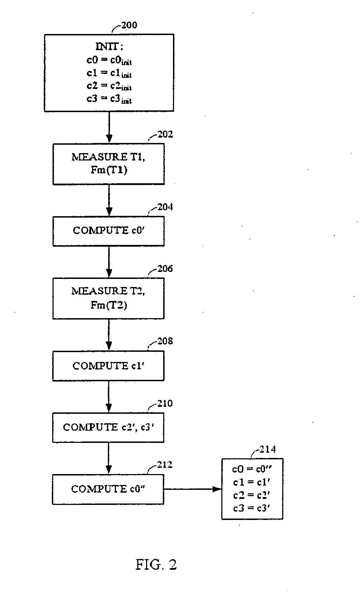

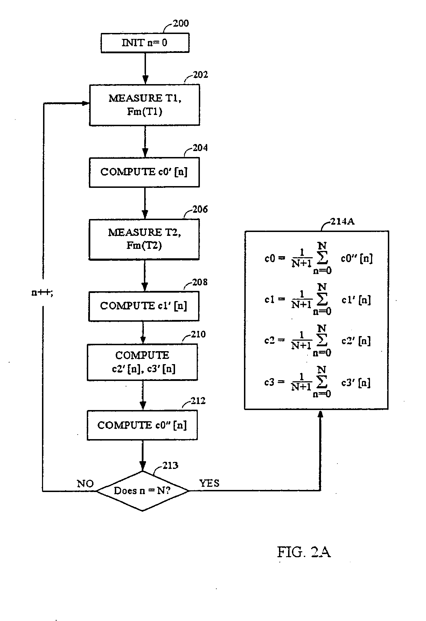

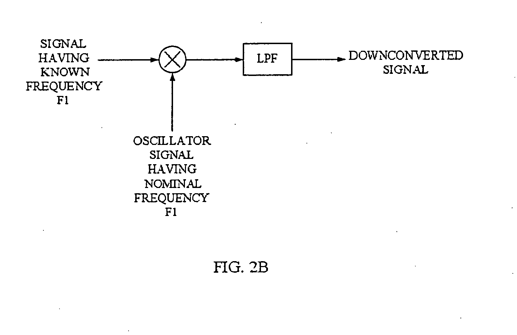

FIG 2 depicts steps according to the present disclosure for estimating the coefficients c0, c1, c2, c3. In an embodiment, the steps depicted in FIG 2 may be performed in the factory.

At step 200, initial values for c0, c1, c2, c3 are loaded from a memory. In FIG 2, the initial values loaded are designated as $c0_{init}$, $c1_{init}$, $c2_{init}$, $c3_{init}$, respectively. In an embodiment, $c0_{init}$ is set to zero. In an embodiment, $c1_{init}$, $c2_{init}$, $c3_{init}$ are set to the values of the coefficients a1, a2, a3, respectively, characterizing the crystal, according to Equation 1. The coefficients a1, a2, a3 may be calculated from, e.g., data provided by the crystal vendor. In an embodiment, the coefficients a1, a2, a3 may be estimated by averaging data from multiple crystal samples as provided by the crystal vendor. Alternatively, the coefficients a1, a2, a3 may be estimated from a nominal F-T curve provided by the crystal vendor.

Returning to FIG 2, at step 202, the temperature T1 of the crystal at an arbitrary time t1 is measured, e.g., using temperature sensor 120 in FIG 1. Also measured is the corresponding oscillator frequency offset Fm(T1) from the reference frequency $F_{O0}$. In an embodiment, the frequency offset Fm(T1) may be measured by injecting a single tone of known frequency F1 into a receiver, tuning the crystal oscillator nominally to the frequency F1, and observing the frequency of the signal after downconversion, as depicted in FIG 2B. The frequency of the signal after downconversion can be used to derive the frequency offset Fm(T1). Note one of ordinary skill in the art will realize that for simplicity, certain blocks have been omitted from the frequency measurement setup depicted in FIG 2B, such as amplifiers and/or other filters.

At step 204, an estimated coefficient c0' is computed based on the information gathered at step 202. In an embodiment, the estimated coefficient c0' is computed as follows (Equation 3):

$$c0' = Fm(T1) - F_{init}(T1),$$

wherein $F_{init}(T1)$ is computed by substituting the initial coefficient estimates $c0_{init}$, $c1_{init}$, $c2_{init}$, $c3_{init}$ into Equation 2, i.e., (Equation 4):

$$F_{init}(T1) = c3_{init}\,(T1 - T_0)^3 + c2_{init}\,(T1 - T_0)^2 + c1_{init}\,(T1 - T_0) + c0_{init}.$$

At step 206, the oscillator frequency at a second temperature T2 is measured, yielding Fm(T2). The temperature T2 is preferably sufficiently separated from T1 to allow accurate estimation of the slope of the F-T curve, but sufficiently near T1 to minimize the effect of the second- and third-order terms. For example, the separation between T1 and T2 may be chosen to be at least one degree Celsius.

In an embodiment, the temperature T2 may be sampled after waiting a predetermined amount of time after time t1 at which T1 is sampled. In an alternative embodiment, a plurality of temperature-frequency data points may be sampled over a time interval, and the lowest temperature may be taken to be T1, and the highest temperature may be taken to be T2. In an embodiment, to further facilitate a sufficient separation between the temperatures T2 and T1, a heat source may be turned on after step 202, to raise the oscillator temperature. In an embodiment, the heat source may be a power amplifier.

At step 208, an estimated coefficient c1' is computed. In an embodiment, c1' may be computed as follows (Equation 5):

$$c1' = [\, Fm(T2) - Fm(T1) \,] \,/\, [T2 - T1].$$

At step 210, estimated coefficients c2' and c3' are computed. In an embodiment, c2' and c3' are assumed to be functions of c1', such that specifying c1' uniquely specifies c2' and c3'. In an embodiment, c2' and c3' are assumed to be linearly related to c1' as follows (Equation 6):

$$c2' = m_{c2'} * c1' + b_{c2'};$$

and

$$c3' = m_{c3'} * c1' + b_{c3'};$$

wherein the linear coefficients $m_{c2'}$, $m_{c3'}$, $b_{c2'}$, $b_{c3'}$ may be empirically determined and/or pre-stored in memory.

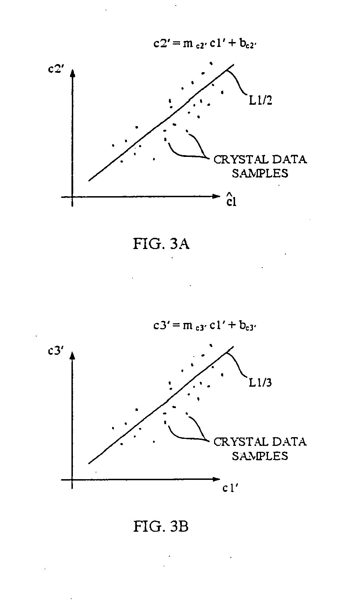

FIG 3A depicts a linear relationship between c1' and c2' denoted by L1/2. In an embodiment, the coefficients $m_{c2'}$ and $b_{c2'}$ characterizing the linear relationship may be derived from multiple crystal data samples as provided by the crystal vendor. These multiple data samples are shown in FIG 3A as a scatter plot superimposed on the line L1/2. Based on the data points, the estimated coefficients $m_{c2'}$ and $b_{c2'}$ may be determined according to predetermined optimality criteria, e.g., minimum mean square error between the line L1/2 and the data samples in the scatter plot.

FIG 3B depicts a similar linear relationship between c1' and c3' that can be used to compute an estimate of c3' from c1'.

In an embodiment, only data from crystal samples manufactured by the same crystal vendor as the crystal being calibrated may be included to estimate the coefficients $m_{c2'}$, $b_{c2'}$, $m_{c3'}$, $b_{c3'}$. In an embodiment, crystal samples from multiple vendors may be included.

Returning to FIG 2, at step 212, an updated estimate c0" for the coefficient c0 may be obtained based on the estimated coefficients c0', c1', c2' and c3' derived in steps 204, 208, and 210. In an embodiment, c0" may be computed as c0" = Fm(T1) - F'(T1), where F'(T1) is computed as follows (Equation 7):

$$F'(T1) = c3' \, (T1 - T_0)^3 + c2' \, (T1 - T_0)^2 + c1' \, (T1 - T_0) + c0'.$$

In step 214, the coefficients c0, c1, c2, c3 may be updated to the values of the computed coefficients c0", c1', c2', c3', respectively. In an embodiment, the updated coefficients may be stored in a memory.

FIG 2A depicts an alternative embodiment of the present disclosure. In FIG 2A, steps 202-212 are each performed a total of N+1 times to obtain multiple estimates of the coefficients c0, c1, c2, c3. Numbered steps in FIG 2A correspond to similarly numbered steps in FIG 2.

In FIG 2A, step 200 initializes the coefficients. In an embodiment, this may be done in the same manner as earlier described with reference to FIG 2. In addition, at step 200, an iteration index n is set to 0. Steps 202-212 proceed as described earlier with reference to FIG 2, with [n] representing the computed coefficient corresponding to each iteration index. At step 213, the algorithm checks for whether the iteration index n has reached N. If not, then the algorithm increments n, and returns to step 202 for the next iteration. If n has reached N, then the algorithm proceeds to step 214.

Upon returning to step 202 for a subsequent iteration, steps 202-212 may be repeated to derive a set of coefficients c0'[n], c1'[n], c2'[n], c3'[n], c0"[n] associated with each iteration index n. In an embodiment, the set of coefficients derived for each iteration index n may be stored in memory for later processing.

In an embodiment, the coefficients c0", c1', c2', c3' from all N+1 iterations may be combined to generate an estimate for the coefficients c0, c1, c2, c3. This may be done by averaging together the sets of estimated coefficients computed during the N+1 total iterations to produce one set of coefficients, as noted in step 214 of FIG 2A.

In another embodiment (not shown), an infinite impulse response (IIR) filter may be used to update the coefficients with each iteration, as follows (Equation 8): $[c0, c1, c2, c3]_{new} = \alpha[c0, c1, c2, c3]_{old} + (1 - \alpha)[c0, c1, c2, c3]_{current}$; $0 < \alpha < 1$.

In this embodiment, $[c0,c1,c2,c3]_{old}$ is the running estimate of the coefficients, $[c0,c1,c2,c3]_{current}$ is the estimate of coefficients computed for the current iteration n, and $[c0,c1,c2,c3]_{new}$ is the updated estimate of coefficients.

In yet another embodiment, instead of averaging or IIR filtering the sets of estimated coefficients, a joint probability maximization method may be employed to derive an optimal set of coefficients based on the N+1 available sets of coefficients. For example, given the plurality of F-T data points sampled in the process of FIG 2A, an optimal set of coefficients $c0_{opt}$, $c1_{opt}$, $c2_{opt}$, $c3_{opt}$ yielding a minimum mean-squared error between the F(T) and the sampled data points may be derived. In an embodiment, to simplify the search process, a linear relationship may be assumed between $c1_{opt}$ and each of coefficients $c2_{opt}$ and $c3_{opt}$, as described previously herein with reference to FIGs 3A and 3B.

One of ordinary skill in the art will note that not all coefficients c0, c1, c2, c3 need to be estimated using the techniques depicted in FIGs 2 and 2A. For example, in an embodiment, only coefficients c0 and c1 are estimated, with the appropriate modifications made to the steps depicted in FIGs 2 and 2A. Such embodiments are contemplated to be within the scope of the present disclosure.

In an embodiment, the steps shown in FIGs 2 and 2A may be performed in the factory, prior to in-field operation of the oscillator circuit. Alternatively, the steps may be performed during in-field operation of the oscillator circuit.

In an embodiment, the steps depicted in FIGs 2 and 2A may be performed once during an initial calibration phase of a device utilizing the crystal oscillator, e.g., during assembly of the device at a factory. In alternative embodiments, the steps depicted in FIG 2 may be performed multiple times as needed.

In an aspect of the present disclosure, the estimates for coefficients c0, c1, c2, c3 may be periodically updated during normal operation to maintain their accuracy over time. Disclosed hereinbelow are techniques to periodically update the coefficient estimates.

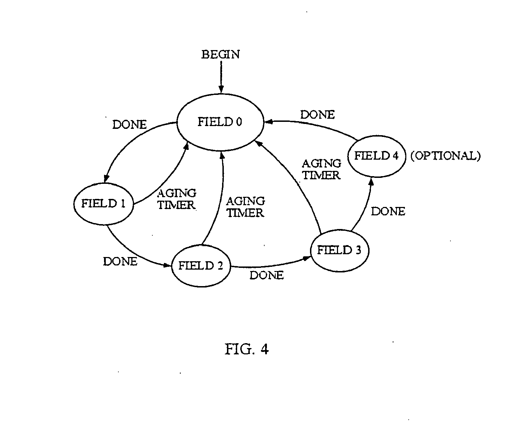

FIG 4 shows a state machine used to re-adjust an initially calibrated set of coefficients derived from, e.g., the procedure described in FIG 2. The re-adjustment may help mitigate the inaccuracies of factory calibration, as well as inaccuracies due to aging of the crystal and/or oscillator.

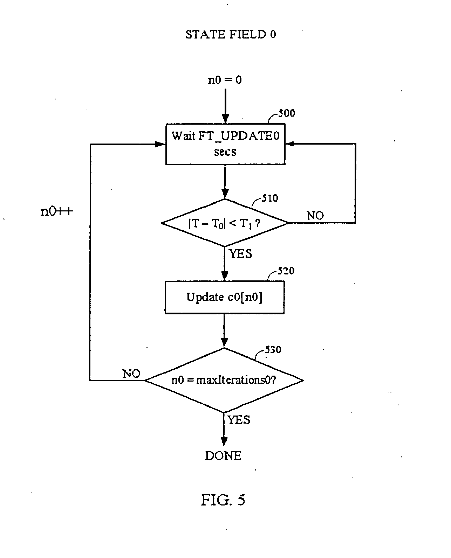

In FIG 4, the re-adjustment procedure begins at state FIELD0. In an embodiment, the state FIELD0 calibrates the coefficient c0. In an embodiment, the calibration of c0 may be done according to operations described later herein with reference to FIG 5. State FIELD0 may transition to state FIELD1 when a predetermined set of conditions (labeled "Done" in FIG 4) are met.

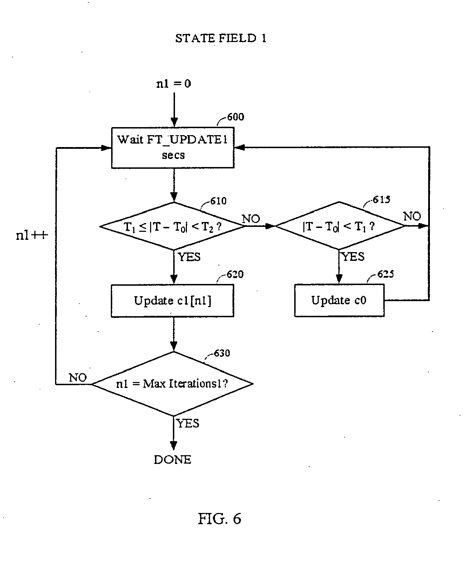

State FIELD1 may calibrate coefficient c1, as well as c0. In an embodiment, the calibration of c0 and c1 may be done according to operations described later herein with reference to FIG 6. State FIELD 1 may transition to state FIELD2 when a predetermined set of conditions are met. State FIELD 1 may also transition back to state FIELD0 if an aging timer expires.

In an embodiment, the aging timer may track the amount of time elapsed since any coefficient has last been updated. The aging timer may be an electronic counter resident on a chip with the oscillator, or it may be a module that compares a time stamp stored during the last coefficient update with the current time stamp. In an embodiment, the aging timer can be set to expire two years after a last calibration.

Referring back to FIG 4, state FIELD2 may calibrate coefficient c2, as well as coefficients c1 and/or c0. State FIELD2 may transition to state FIELD3 when a predetermined set of conditions are met. State FIELD2 may also transition back to FIELD0 if the aging timer expires.

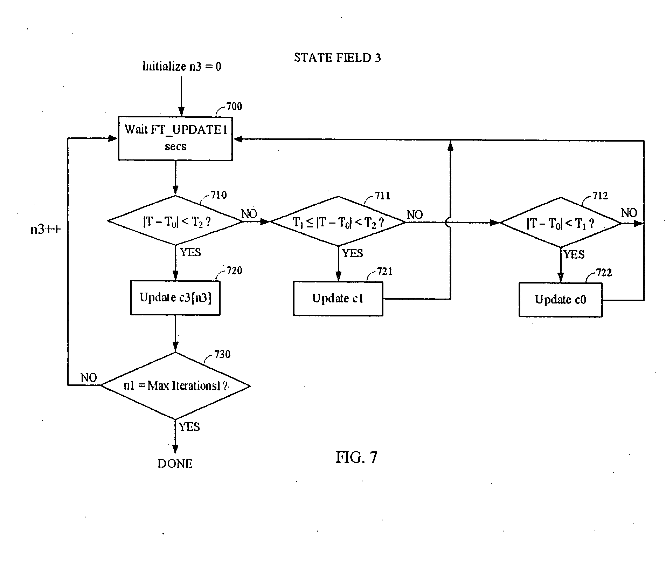

State FIELD3 may calibrate coefficient c3, as well as coefficients c2, c1, and/or c0. In an embodiment, the calibration of c3, c2, c1, c0 may be done according to operations described later herein with reference to FIG 7. State FIELD3 may transition to state FIELD4 when a predetermined set of conditions are met. Alternatively, state FIELD3 may transition back to FIELD0.

In an embodiment, state FIELD4 may be a sleep state. In the sleep state, the calibration mechanism may cease operation for a predetermined amount of time. In an embodiment, the predetermined amount of time may be one year.

Note in an embodiment wherein c2 is approximately zero, state FIELD 1 may skip FIELD2 and transition directly to state FIELD3 upon the predetermined set of conditions being met.

In an embodiment, the current state (i.e., FIELD0, FIELD1, FIELD2, FIELD3, or FIELD4) of the state machine is stored in nonvolatile memory, such that the state is preserved upon power-up or power-down of a device utilizing the crystal oscillator. In an embodiment, the crystal oscillator may be used in a wireless handset.

FIG 5 shows an embodiment of operations performed during state FIELD0. Note the embodiment illustrated in FIG 5 is not meant to limit the scope of the disclosure to any particular set of operations in FIELD0. Rather, one of ordinary skill in the art will realize that any steps used to update an estimate of the coefficients may be performed during any of the states FIELD0, FIELD1, FIELD2, FIELD3, and FIELD4. Such embodiments are contemplated to be within the scope of the present disclosure.

In state FIELD0, a counter n0 for counting iterations of a loop is initialized to zero. At the first step 500, the state machine commences by waiting for a period of time FT_update0 seconds. At the end of FT_update0 seconds, the temperature T (e.g., in degrees Celsius) of the crystal is measured. At step 510, it is checked whether the temperature T falls within a range $|T-T_0|<T_1$ degrees. If yes, the current estimate c0[n0] for coefficient c0 is updated according to step 520. If no, then the state machine may return to step 500 to wait for another FT_update0 seconds.

In an embodiment, $T_0$ is set to 30 degrees Celsius, and $T_1$ is set to 15 degrees Celsius.

In an embodiment, at step 520, the coefficient c0[n0] may be updated by an IIR filter as follows (Equation 9):

$$c0[n0+1] = c0[n0] + \frac{(fm - fcal - c0[n0])}{N0};$$

where c0[n0] is the estimated coefficient c0 at iteration n0, *fm* is the actual measured frequency of the oscillator, *fcal* is the oscillator frequency as estimated using, e.g., Equation 2 assuming the current (as of iteration nO) set of coefficients, and *N*0 is a weighting constant. Note for n0=0, the coefficient c0[0] may be assumed to be the last c0 stored in memory.

In an embodiment, the actual measured frequency of the oscillator *fm* may be derived from an automatic frequency control circuit used in, for example, a receiver apparatus for code-division multiple access (CDMA). One of ordinary skill in the art will realize that there are alternative ways of measuring an actual frequency of the oscillator during in-field operation.

At step 530, n0 is compared to a variable maxIterations0. If n0 has reached a variable maxIterations0, then the state machine exits state FIELD0 and proceeds to the next state. If n0 has not reached maxIterations0, then the state returns to step 500.FIG 6 shows an embodiment of operations performed during state FIELD1. In state FIELD1, a counter n1 for counting the iterations is initially set to zero. At step 600, the state machine waits for a period of time FT_update1 seconds. At the end of FT_update1 seconds, the temperature T (e.g., in degrees Celsius) of the crystal is measured. At step 610, it is checked whether T falls within the range $T_1 \leq |T - T_0| < T_2$. If yes, then the current estimate c1[n1] for coefficient c1 may be updated according to step 620. If no, then the state proceeds to step 615, wherein the state machine checks whether T falls within the range. If yes, then the current estimate for c0 is updated in step 625. If no, the state machine returns to step 600 to wait for FT_update1 seconds.

In an embodiment, the operations in step 625 can be identical to the operations described with reference to step 520 in FIG 5. In an embodiment (not shown), an iteration index may also be provided for updating coefficient c0.

In an embodiment, $T_2$ is 30 degrees Celsius.

At step 620, the coefficient c1[n1] is updated.

In an embodiment, c1[n1] may be updated as follows. Given the current value of c0, candidate values of c1 [n1] may be assessed to determine the best c1 candidate for the measured frequency and temperature, according to some optimality criteria. In an embodiment, the optimality criteria may include the error between a measured temperature-frequency pair and the computed temperature-frequency characteristic, assuming the current value of c0 and a candidate value of c1. In an embodiment, the search for the best c1 may be aided by assuming a linear relationship between c1 and c2/c3, e.g., as described with reference to FIGs 3A and 3B.

In an embodiment, once a best candidate c1 is determined, that c1 may be IIR filtered with a previous estimate of c1.

In another embodiment, the coefficient c1[n1] may be determined by computing the following metric:

$$c1[n1] = \frac{Fm(T2) - Fm(T1)}{T2 - T1};$$

and then IIR filtering the computed coefficient c1[n1] with a previous c1[n1-1]. In an embodiment, the IIR weighting constant can be 256.

At step 630, n1 is compared to a variable maxIterations1. If n1 has reached maxIterations0, then the state machine exits state FIELD 1 and proceeds to the next state. If n1 has not reached maxIterations1, then the state returns to step 600.

In an embodiment, state FIELD2 may be implemented similarly to the states FIELD0 and FIELD1 previously described. In an alternative embodiment, FIELD2 need not be implemented if the coefficient c2 is predetermined to be close to zero. In this embodiment, state FIELD 1 may bypass FIELD2 and directly transition to FIELD3.

FIG 7 shows an embodiment of the operations performed during state FIELD3. In state FIELD3, a counter n3 for counting the iterations is initially set to zero. At step 700, the state machine waits for a period of time FT_update3 seconds. At the end of FT_update3 seconds, the temperature T (e.g., in degrees Celsius) of the crystal is measured. In an embodiment, at step 710, if $|T-T_0|>T_2$ degrees, then the current estimate for c3 is updated at step 720.

In an embodiment, at step 720, given the most recent values of c0, c1, and c2, candidate values of c3 may be assessed to determine the best c3 for the measured frequency and temperature, according to some optimality criteria. Once a best c3 is determined, it may be IIR filtered with a previous estimate of c3.

At step 730, n3 is compared to a variable maxIterations3. If n3 has reached maxIterations0, then the state machine proceeds to the next state. If n3 has not reached maxIterations3, then the state returns to step 700.

In alternative embodiments of the present disclosure, other criteria may be used to determine when the state machine proceeds from one state to the next state. For example, instead of transitioning to the next state only after a predetermined number of iterations, as shown in FIGs 5, 6, and 7, the state machine may transition to the next state upon detecting little or no change in the coefficient to be updated. In an embodiment, for example, the state machine may transition from FIELD0 to FIELD1 if $|c0[n0] - c0[n0-1]| <$ delta, where delta has a suitably small value. Such embodiments are contemplated to be within the scope of the present disclosure.

In one or more exemplary embodiments, the functions described may be implemented in hardware, software, firmware, or any combination thereof. If implemented in software, the functions may be stored on or transmitted over as one or more instructions or code on a computer-readable medium. Computer-readable media includes both computer storage media and communication media including any medium that facilitates transfer of a computer program from one place to another. A storage media may be any available media that can be accessed by a computer. By way of example, and not limitation, such computer-readable media can comprise RAM, ROM, EEPROM, CD-ROM or other optical disk storage, magnetic disk storage or other magnetic storage devices, or any other medium that can be used to carry or store desired program code in the form of instructions or data structures and that can be accessed by a computer. Also, any connection is properly termed a computer-readable medium. For example, if the software is transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, DSL, or wireless technologies such as infrared, radio, and microwave are included in the definition of medium..Disk and disc, as used herein, includes compact disc (CD), laser disc, optical disc, digital versatile disc (DVD), floppy disk and blu-ray disc where disks usually reproduce data magnetically, while discs reproduce data optically with lasers. Combinations of the above should also be included within the scope of computer-readable media.

A number of aspects and examples have been described. However, various modifications to these examples are possible, and the principles presented herein may be applied to other aspects as well. These and other aspects are within the scope of the following claims.

**Claims**

1. A method for computing coefficients for use in a polynomial approximation of a crystal oscillator frequency, the polynomial comprising a term c0' and a coefficient c1' times a measured temperature T of the crystal oscillator, the method comprising:

   measuring a first temperature T1 and a corresponding oscillator frequency Fm(T1);
   measuring a second temperature T2 and a corresponding oscillator frequency Fm(T2);
   computing the coefficient c0' based on Fm(T1); and
   computing the coefficient c1' based on T1, T2, Fm(T1), and Fm(T2).

2. The method of claim 1, the computing the coefficient c0' comprising taking the difference between Fm(T1) and an initial term $F_{init}$(T1).

3. The method of claim 2, the initial term $F_{init}$(T1) comprising a term $c0_{init}$ and a coefficient $c1_{init}$ times T1.

4. The method of claim 1, the computing the coefficient c1' comprising dividing the difference between Fm(T2) and Fm(T1) by the difference between T2 and T1.

**5.** The method of claim 4, wherein the difference between T1 and T2 is at least one degree Celsius.

**6.** The method of claim 4, further comprising turning on a heat source after measuring T1 and before measuring T2.

**7.** The method of claim 6, wherein the heat source is a power amplifier.

**8.** The method of claim 1, further comprising computing multiple estimates of c0' and c1'.

**9.** The method of claim 8, further comprising averaging together the multiple estimates of c0' and c1'.

**10.** The method of claim 8, further comprising updating estimates of c0' and c1' using an infinite impulse response (IIR) filter.

**11.** The method of claim 4, the polynomial further comprising a coefficient c2' times a second-order function of T and a coefficient c3' times a third-order function of T, the method further comprising:

   computing the coefficients c2' and c3' based on c1'.

**12.** The method of claim 11, the computing the coefficient c2' comprising multiplying c1' by a term $m_{c2'}$.

**13.** The method of claim 11, the computing the coefficient c3' comprising multiplying c1' by a term $m_{c3'}$.

**14.** The method of claim 13, further comprising updating the term c0' by taking the difference between Fm(T1) and F'(T1), wherein F'(T1) comprises the pre-updated term c0', and the computed coefficients c1', c2', and c3'.

**15.** The method of claim 13, further comprising computing multiple estimates of c0', c1', c2', and c3'.

**16.** The method of claim 15, further comprising averaging together the multiple estimates of c0', c1', c2', and c3'.

**17.** The method of claim 15, further comprising updating estimates of c0', c1', c2', and c3' using an infinite impulse response (IIR) filter.

**18.** The method of claim 15, further comprising updating estimates of c0', c1', c2', and c3' by minimizing a mean-squared error between: 1) a frequency estimate based on candidate estimates of c0', c1', and 2) the measured frequency Fm(T1).

**19.** The method of claim 18, the frequency estimate based on candidate estimates of c0', c1' utilizing estimates for c2' and c3' linearly related to the candidate estimates of c0' and c1'.

**20.** The method of claim 1, wherein the computing the estimates of c0' and c1' is done at a factory.

**21.** A method for computing coefficients for use in a polynomial approximation of a crystal oscillator frequency, the polynomial comprising a term c0' and a coefficient c1' times a measured temperature T of the crystal oscillator, the method comprising:

   entering a state FIELD0, operations in the state FIELD0 comprising computing the coefficient c0' if the measured temperature T is within a first range of temperatures; and
   entering a state FIELD1, operations in the state FIELD1 comprising computing the coefficient c1' if the measured temperature T is within a second range of temperatures.

**22.** The method of claim 21, the computing the coefficient c0' comprising:

   taking a difference between a measured frequency *fm* and a calculated frequency *fcal* to generate a first difference term, wherein *fcal* is calculated from a previous estimate of the coefficient c0' and the measured temperature T.

**23.** The method of claim 22, the computing the coefficient c0' further comprising:

weighting a difference between the first difference term and a previous estimate of the coefficient c0' by a weighting constant; and

adding the weighted difference to the previous estimate of c0'.

24. The method of claim 23, the computing the coefficient c1' comprising:

measuring temperatures T2 and T1, and corresponding frequencies Fm(T2) and Fm(T1);
dividing the difference between Fm(T2) and Fm(T1) by the difference between T2 and T1 to generate a first quotient;
weighting the first quotient by a weighting constant; and
adding the weighted quotient to the previous estimate of c1'.

25. The method of claim 24, operations in the state FIELD0 further comprising waiting for a first predetermined time period before checking if the measured temperature T is within the first range of temperatures, operations in the state FIELD 1 further comprising waiting for a second predetermined time period before checking if the measured temperature T is within the second range of temperatures.

26. The method of claim 25, further comprising transitioning from FIELD0 to FIELD1 if c0' has been computed a first predetermined number of times in FIELD0.

27. The method of claim 25, further comprising transitioning from FIELD0 to FIELD1 if the difference between a current estimate of c0' and a previous estimate of c0' is less than a predetermined value.

28. The method of claim 25, further comprising transitioning from FIELD0 back to FIELD1 if a predetermined condition is met.

29. The method of claim 25, further comprising entering a state FIELD3, operations in the state FIELD3 comprising computing the coefficient c3' if the measured temperature T is within a fourth range of temperatures, operations in the state FIELD3 further comprising waiting for a fourth predetermined time period before checking if the measured temperature T is within the fourth range of temperatures.

30. The method of claim 29, the computing the coefficient c3' comprising determining an estimate of c3' that minimizes a mean-squared error between: 1) a frequency estimate based on the updated values of c0, c1, c2, and a candidate estimate of c3', and 2) the measured frequency Fm(T1).

31. The method of claim 30, further comprising IIR filtering the estimate of c3' with a previous estimate of c3'.

32. The method of claim 31, further comprising transitioning from FIELD 1 to FIELD3 if c1' has been computed a second predetermined number of times.

33. The method of claim 31, further comprising transitioning from FIELD1 to FIELD3 if the difference between a current estimate of c1' and a previous estimate of c1' is less than a predetermined value.

34. An apparatus for computing coefficients for use in a polynomial approximation of a crystal oscillator frequency, the polynomial comprising a term c0' and a coefficient c1' times a measured temperature T of the crystal oscillator, the apparatus comprising:

a temperature measurement unit for measuring a first temperature T1 and a second temperature T2;
a frequency measurement unit for measuring corresponding oscillator frequencies Fm(T1) and Fm(T2); and
a computing module for computing the coefficient c0' based on Fm(T1), and for computing the coefficient c1' based on T1, T2, Fm(T1), and Fm(T2).

35. The apparatus of claim 34, the computing module computing the coefficient c0' by taking the difference between Fm(T1) and an initial term $F_{i-nit}$ (T1).

36. The apparatus of claim 34, the computing module computing the coefficient c1' by dividing the difference between Fm(T2) and Fm(T1) by the difference between T2 and T1.

**37.** The apparatus of claim 34, the polynomial further comprising a coefficient c2' times a second-order function of T, the computing module further computing the coefficient c2' by performing a linear operation on the computed coefficient c1'.

**38.** The apparatus of claim 37, the polynomial further comprising a coefficient c3' times a third-order function of T, the computing module further computing the coefficient c3' by performing a linear operation on the computed coefficient c1'.

**39.** An apparatus for computing coefficients for use in a polynomial approximation of a crystal oscillator frequency, the polynomial comprising a term c0' and a coefficient c1' times a measured temperature T of the crystal oscillator, the apparatus comprising:

   means for measuring a first temperature T1 and a second temperature T2;
   means for measuring corresponding oscillator frequencies Fm(T1) and Fm(T2);
   means for computing the coefficient c0' based on Fm(T1), and for computing the coefficient c1' based on T1, T2, Fm(T1), and Fm(T2).

**40.** A computer program product for computing coefficients for use in a polynomial approximation of a crystal oscillator frequency, the polynomial comprising a term c0' and a coefficient c1' times a measured temperature T of the crystal oscillator, the product comprising:

   computer-readable medium comprising:

      code for causing a computer to measure a first temperature T1 and a corresponding oscillator frequency Fm(T1);
      code for causing a computer to measure a second temperature T2 and a corresponding oscillator frequency Fm(T2);
      code for causing a computer to compute the coefficient c0' based on Fm(T1);
      code for causing a computer to compute the coefficient c1' based on T1, T2, Fm(T1), and Fm(T2).

**41.** An apparatus for computing coefficients for use in a polynomial approximation of a crystal oscillator frequency, the polynomial comprising a term c0' and a coefficient c1' times a measured temperature T of the crystal oscillator, the apparatus comprising:

   means for entering a state FIELD0, operations in the state FIELD0 comprising computing the coefficient c0' if the measured temperature T is within a first range of temperatures; and
   means for entering a state FIELD 1, operations in the state FIELD1 comprising computing the coefficient c1' if the measured temperature T is within a second range of temperatures.

**42.** The apparatus of claim 41, the computing the coefficient c0' comprising taking a difference between a measured frequency *fm* and a calculated frequency *fcal* to generate a first difference term, wherein *fcal* is calculated from a previous estimate of the coefficient c0' and the measured temperature T.

**43.** A computer program product for computing coefficients for use in a polynomial approximation of a crystal oscillator frequency, the polynomial comprising a term c0' and a coefficient c1' times a measured temperature T of the crystal oscillator, the product comprising:

   computer-readable medium comprising:

      code for causing a computer to enter a state FIELD0, operations in the state FIELD0 comprising computing the coefficient c0' if the measured temperature T is within a first range of temperatures; and
      code for causing a computer to enter a state FIELD 1, operations in the state FIELD1 comprising computing the coefficient c1' if the measured temperature T is within a second range of temperatures.

**44.** The computer program product of claim 43, the code for causing a computer to compute the coefficient c0' comprising code for causing a computer to take a difference between a measured frequency *fm* and a calculated frequency *fcal* to generate a first difference term, wherein *fcal* is calculated from a previous estimate of the coefficient c0' and the measured temperature T.

**45.** The computer program product of claim 43, the code for causing a computer to compute the coefficient c0' further comprising:

code for causing a computer to weight a difference between the first difference term and a previous estimate of the coefficient c0' by a weighting constant; and
code for causing a computer to add the weighted difference to the previous estimate of c0'.

**46.** The computer program product of claim 45, the code for causing a computer to compute the coefficient c1' comprising:

code for causing a computer to measure temperatures T2 and T1, and corresponding frequencies Fm(T2) and Fm(T1);
code for causing a computer to divide the difference between Fm(T2) and Fm(T1) by the difference between T2 and T1 to generate a first quotient;
code for causing a computer to weight the first quotient by a weighting constant; and
code for causing a computer to add the weighted quotient to the previous estimate of c1'.

**47.** The computer program product of claim 46, operations in the state FIELD0 further comprising waiting for a first predetermined time period before checking if the measured temperature T is within the first range of temperatures, operations in the state FIELD1 further comprising waiting for a second predetermined time period before checking if the measured temperature T is within the second range of temperatures.

**48.** The computer program product of claim 47, the computer-readable medium further comprising code for causing a computer to transition from FIELD0 to FIELD1 if c0' has been computed a first predetermined number of times in FIELD0.

**49.** The computer program product of claim 48, the computer-readable medium further comprising code for causing a computer to enter a state FIELD3, operations in the state FIELD3 comprising computing the coefficient c3' if the measured temperature T is within a fourth range of temperatures, operations in the state FIELD3 further comprising waiting for a fourth predetermined time period before checking if the measured temperature T is within the fourth range of temperatures.

**50.** The computer program product of claim 49, the computer-readable medium further comprising code for causing a computer to transition from FIELD1 to FIELD3 if c1' has been computed a second predetermined number of times.

CRYSTAL
(X)

100

OSCILLATOR
CIRCUIT
(OSC)

110

OUTPUT
SIGNAL
110a

TEMPERATURE
SENSOR

120

→ T

FIG. 1

FIG. 1A

FIG. 2

FIG. 2A

SIGNAL
HAVING
KNOWN
FREQUENCY
F1 ———→ ⊗ ——→ | LPF | ——→ DOWNCONVERTED
SIGNAL

OSCILLATOR
SIGNAL
HAVING
NOMINAL
FREQUENCY
F1

FIG. 2B

$$c2' = m_{c2'} \, c1' + b_{c2'}$$

FIG. 3A

$$c3' = m_{c3'} \, c1' + b_{c3'}$$

FIG. 3B

BEGIN

FIELD 0

DONE

DONE

FIELD 4 (OPTIONAL)

AGING TIMER

FIELD 1

AGING TIMER

AGING TIMER

DONE

DONE

DONE

FIELD 2

DONE

FIELD 3

FIG. 4

STATE FIELD 0

FIG. 5

STATE FIELD 1

n1 = 0

Wait FT_UPDATE1 secs — 600

$T_1 \leq |T - T_0| < T_2$ ? — 610

NO

$|T - T_0| < T_1$ ? — 615

NO

YES

YES

Update c1[n1] — 620

Update c0 — 625

n1++

n1 = Max Iterations1? — 630

NO

YES

DONE

FIG. 6

Initialize n3 = 0          STATE FIELD 3

700 Wait FT_UPDATE1 secs

n3++

710 $|T - T_0| < T_2$ ? — NO → 711 $T_1 \leq |T - T_0| < T_2$ ? — NO → 712 $|T - T_0| < T_1$ ? — NO

710 YES ↓ 720 Update c3[n3]

711 YES ↓ 721 Update c1

712 YES ↓ 722 Update c0

730 n1 = Max Iterations1 ?  — NO

730 YES ↓ DONE

FIG. 7

EP 2 085 900 A1

22

Europäisches
Patentamt

European
Patent Office

Office européen
des brevets

## EUROPEAN SEARCH REPORT

Application Number

EP 08 00 5890

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | PERETTO L ET AL: "A System for the Measurement of the Temperature Dependence Performances of Quartz Oscillators: a Study of the Analytical Model of the Failure Rate" INSTRUMENTATION AND MEASUREMENT TECHNOLOGY CONFERENCE PROCEEDINGS, 200 7 IEEE, IEEE, PI, 1 May 2007 (2007-05-01), pages 1-6, XP031182227 ISBN: 978-1-4244-0588-6 the whole document, in particular Fig. 1 "The Test and Measurement System" and Fig. 4 ----- | 1-50 | INV. G06F17/50 |
| A,D | BALLATO A: "Frequency-temperature-load capacitance behavior of resonators for TCXO application" IEEE TRANSACTIONS ON SONICS AND ULTRASONICS USA, vol. SU-25, no. 4, July 1978 (1978-07), pages 185-191, XP002528763 ISSN: 0018-9537 the whole document, in particular chapter "Frequency-Temperature Behavior" ----- | 1-50 | |

TECHNICAL FIELDS
SEARCHED      (IPC)

G06F

The present search report has been drawn up for all claims

| Place of search | Date of completion of the search | Examiner |
|---|---|---|
| Munich | 20 May 2009 | Lerbinger, Klaus |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons
    ......................................................................
& : member of the same patent family, corresponding
     document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

• **Arthur Ballato.** Frequency-Temperature-Load Capacitance Behavior of Resonators for TCXO Application. *IEEE Trans. Sonics and Ultrasonics,* July 1978, vol. SU-25 (4